# FASCICULE DE BREVET EUROPEEN

(11) **EP 3 164 938 B1**
(45) Date de publication et mention de la délivrance du brevet: **12.12.2018**
(21) Numéro de dépôt: 15745243.4
(22) Date de dépôt: 01.07.2015
(51) Int. Cl.: H02S 20/23, H02S 40/36

(54) **PANNEAU MUNI D'UN DISPOSITIF PHOTOVOLTAIQUE**
MIT EINER PHOTOVOLTAISCHEN VORRICHTUNG AUSGESTATTETE TAFEL
PANEL EQUIPPED WITH A PHOTOVOLTAIC DEVICE

(30) Priorité: 01.07.2014 WO PCT/IB2014/001240
(43) Date de publication de la demande: 10.05.2017
(73) Titulaire: ArcelorMittal, 1160 Luxembourg (LU)
(72) Inventeur: VIGNAL, Renaud, 74320 Sévrier (FR); GERON, Laurent, 4632 Cerexhe-Heuseux (BE)
(74) Mandataire: Plaisant, Sophie Marie
(86) Numéro de dépôt international: PCT/IB2015/001092
(87) Numéro de publication internationale: WO 2016/001738

(56) Documents cités:
- WO-A1-2011/144546
- WO-A1-2013/010054
- FR-A1- 2 923 082
- FR-A1- 2 947 099
- FR-A1- 2 950 911
- JP-A- H0 685 306
- JP-A- H11 141 064
- JP-A- 2003 314 011
- US-A1- 2001 034 982

## Description

La présente invention concerne un panneau de parement extérieur de bâtiment muni d'un dispositif photovoltaïque. Un tel panneau est destiné principalement à la réalisation de toitures photovoltaïques sans toutefois y être limité.

Il est connu d'équiper les toitures des bâtiments au moyen d'un ensemble de modules photovoltaïques reliés électriquement entre eux de sorte à permettre la production d'énergie électrique.

Les modules photovoltaïques sont formés d'un ensemble de cellules photovoltaïques reliées en série. Plus précisément, les cellules sont rangées en colonnes, les colonnes étant reliées les unes aux autres de sorte à former une sorte de ruban plié. Chaque module présente en périphérie deux pôles électriques situés à proximité l'un de l'autre sous la forme d'une sortie + et une sortie -.

Lors de l'assemblage des modules en toiture, on cherche d'une part à minimiser le métrage de câble et d'autre part à éviter que le câblage ne forme des boucles d'induction qui perturberaient la production d'énergie.

Pour ce faire, il est connu notamment de CN103151409 de câbler les modules « à l'horizontale » comme illustré à la figure 1. Dans une première rangée, les modules, dont les pôles électriques sont situés en partie supérieure, sont reliés en série. Cette rangée est connectée à la rangée supérieure faite de modules reliés entre eux en série et dont les pôles électriques sont situés en partie inférieure. Ce type de câblage permet d'avoir une boucle d'induction de taille réduite mais présente plusieurs inconvénients :
- le raccordement de deux modules successifs se fait en face arrière, ce qui peut nécessiter d'avoir accès à la sous-toiture,
- Si l'on souhaite mettre en toiture un nombre impair de rangées de modules, le câblage devient plus compliqué et nécessite beaucoup de câble,
- La sortie des câbles se fait sur le coté de la toiture, ce qui nécessite également un accès en sous-toiture pour relier les câbles au réseau électrique.

Il est également connu de WO2011/144546 de câbler les modules par l'intermédiaire d'un système de connexion permettant le raccordement aux convertisseurs électronique de puissance de l'installation photovoltaïque au niveau du faitage de la toiture. Ce système de connexion rend cependant complexe la connexion électrique de deux éléments de toiture adjacents. Lors de la mise en place de la toiture photovoltaïque, il est en effet nécessaire de réaliser manuellement plusieurs étapes postérieurement à l'assemblage de deux panneaux adjacents longitudinalement avant que les deux panneaux ne soient électriquement connectés. Il est en effet nécessaire de positionner un boitier à cheval entre les deux panneaux adjacents, de monter des conducteurs électriques sur des supports, d'injecter un gel de silicone,...

La présente invention a pour but de pallier aux problèmes précités en proposant un panneau de parement extérieur de bâtiment muni d'un dispositif photovoltaïque facilitant la mise en place d'une toiture photovoltaïque en minimisant les opérations à réaliser sur chantier et en simplifiant les opérations restantes.

A cet effet, l'invention a pour premier objet un panneau muni d'un dispositif photovoltaïque constitué d'un nombre pair de colonnes de modules photovoltaïques, les colonnes étant alignées sensiblement parallèlement à un bord longitudinal du panneau, chaque colonne comprenant un pôle électrique à chacune de ses extrémités, la polarité d'un pôle électrique d'une extrémité étant inverse de celle du pôle électrique de l'autre extrémité, les pôles de deux colonnes adjacentes étant de polarité inversée, le pôle électrique se présentant sous la forme d'un connecteur mâle lorsqu'il est d'une polarité et sous la forme d'un connecteur femelle lorsqu'il est de polarité inverse et les connecteurs mâles et femelles étant agencés de sorte qu'ils s'emboitent les uns dans les autres lorsque le bord transversal inférieur d'un panneau supérieur vient recouvrir le bord transversal supérieur d'un panneau inférieur.

Le panneau selon l'invention peut également comprendre les caractéristiques optionnelles suivantes, prises isolément ou en combinaison :
- le panneau est fait d'une tôle métallique mise en forme,
- les modules photovoltaïques sont des rubans souples collés sur le panneau,
- les modules photovoltaïques ont été réalisés directement sur le panneau par dépôts successifs de couches de natures appropriées par des procédés de dépôt sous vide,
- les colonnes ne sont pas reliées électriquement entre elles,
- les colonnes sont de longueur identique et leurs extrémités sont alignées sensiblement parallèlement à un bord transversal du panneau,

Un second objet de l'invention est constitué par un assemblage de panneaux selon l'invention juxtaposés par recouvrement marginal de leurs bords longitudinaux et/ou de leurs bords transversaux de sorte à former dans le sens longitudinal des rangées de modules photovoltaïques.

Un troisième objet de l'invention est constitué par un dispositif électrique apte à être raccordé à un convertisseur comprenant un assemblage selon l'invention incliné selon une pente donnée pour lequel :
- en bas de pente de l'assemblage, le pôle électrique de l'extrémité inférieure de la première rangée est connecté électriquement au pôle électrique de l'extrémité inférieure de la deuxième rangée, et ainsi de suite,
- au niveau du recouvrement marginal de deux panneaux adjacents d'une même rangée, le pôle électrique de l'extrémité inférieure de chaque colonne du panneau supérieur est connecté au pôle électrique de polarité inverse en regard sur le panneau inférieur,
- au faitage, les pôles électriques des extrémités supérieures des rangées sont raccordés au convertisseur ou entre eux de façon similaire à ce qui est fait en bas de pente.

Un quatrième objet de l'invention est constitué par un procédé de raccordement électrique, à un convertisseur, des panneaux constitutifs d'un assemblage selon l'invention incliné selon une pente, comprenant les étapes selon lesquelles :
- en bas de pente de l'assemblage, le pôle électrique de l'extrémité inférieure de la première rangée est connecté électriquement au pôle électrique de l'extrémité inférieure de la deuxième rangée, et ainsi de suite,
- Au niveau du recouvrement marginal de deux panneaux adjacents d'une même rangée, le pôle électrique de l'extrémité inférieure de chaque colonne du panneau supérieur est connecté au pôle électrique de polarité inverse en regard sur le panneau inférieur,
- Au faitage, les pôles électriques des extrémités supérieures des rangées sont raccordés au convertisseur ou entre eux de façon similaire à ce qui est fait en bas de pente.

D'autres caractéristiques et avantages de l'invention apparaitront à la lecture de la description qui va suivre.

L'invention sera mieux comprise à la lecture de la description qui suit, donnée à titre explicatif mais non limitatif, en référence aux figures annexées qui représentent :
- La figure 1 est une représentation schématique d'un assemblage de panneaux selon l'art antérieur,
- La figure 2 est une représentation schématique en perspective d'un panneau selon une variante de l'invention,
- La figure 3 est une représentation schématique d'un assemblage de panneaux selon une variante de l'invention,
- La figure 4 est une représentation schématique d'un assemblage de panneaux selon une variante de l'invention.

Les mêmes numéros de référence représentent les mêmes éléments dans chacune des figures.

Dans l'ensemble du texte, on entendra par panneau un élément de forme plate, c'est-à-dire de faible épaisseur comparée à ses autres dimensions. Le panneau peut se présenter sous la forme d'une plaque ou d'une feuille constituée d'un matériau unique ou d'un assemblage composite. Dans ce dernier cas, le panneau est une superposition de plusieurs couches du même matériau ou de matériaux différents. Le matériau en question peut être, entre autre, un matériau métallique, un polymère ou encore une céramique. On pourra citer à titre d'exemple non limitatif de matériaux métalliques l'acier, l'aluminium, le cuivre, le zinc. De préférence le panneau est une tôle métallique. De préférence, il s'agit d'acier préalablement galvanisé et prélaqué afin de le protéger de la corrosion. Le panneau peut optionnellement être moussé en face inférieure et ainsi constituer le parement extérieur d'un panneau sandwich.

Dans le cadre de l'invention, le panneau aura été de préférence préalablement mis en forme au moyen de tout procédé connu de mise en forme parmi lesquels on citera à titre d'exemple non limitatif le pliage, le profilage, l'emboutissage, le moulage.

Cette mise en forme conduit notamment à la formation de nervures à la surface du panneau. Dans l'ensemble du texte on entendra par nervure une saillie formée à la surface du panneau. La nervure peut être de forme trapézoïdale, comme dans le cas des exemples de réalisation présentés ci-après, ou de forme rectangulaire, ondulée, sinusoïdale ou encore en oméga, par exemple. Elle comprend une partie centrale supérieure et deux ailes latérales.

Pour former une toiture ou une façade, les panneaux sont assemblés par recouvrement marginal de leurs bords longitudinaux et de leurs bords transversaux et fixés à la structure porteuse du bâtiment par l'intermédiaire de moyens de fixation tels que des vis, des clous ou encore des rivets.

Dans l'ensemble du texte, on entendra par module photovoltaïque un ensemble apte à convertir l'énergie solaire en électricité et délimité par une barrière protectrice qui isole de l'extérieur des cellules photovoltaïques toutes reliées électriquement entre elles.

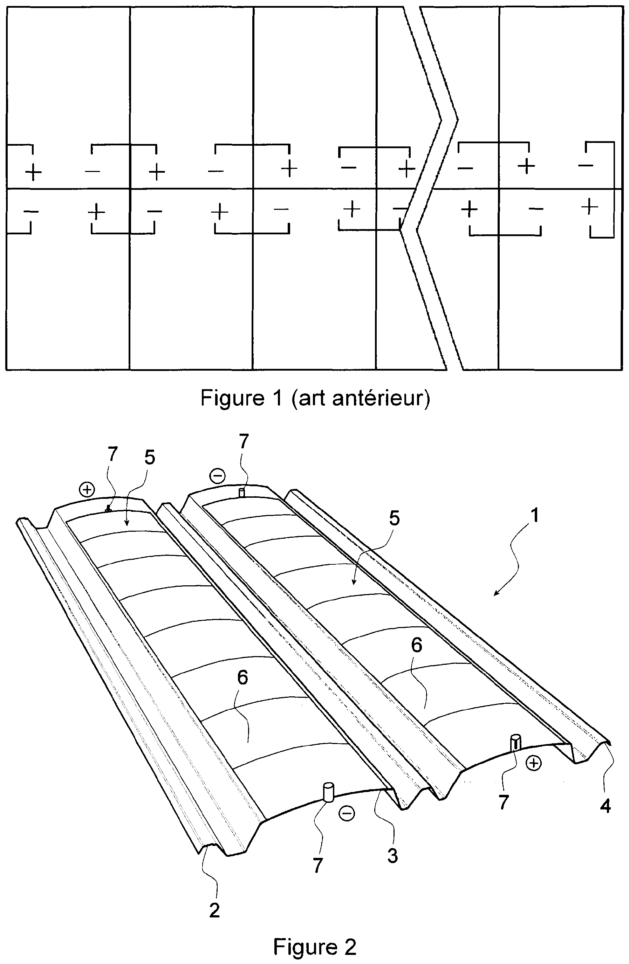

En référence à la figure 2, le panneau 1 est principalement constitué d'un premier bord longitudinal 2, d'une partie centrale 3 au moins partiellement recouverte d'un dispositif photovoltaïque et d'un second bord longitudinal 4.

Le dispositif photovoltaïque est constitué d'un nombre pair de colonnes 5 de modules photovoltaïques disposées sur la face supérieure du panneau. Chacune des colonnes comprend au moins un module photovoltaïque formé d'un ensemble de cellules photovoltaïques 6. Il peut s'agir à titre d'exemple non limitatif d'un module sous forme de ruban souple collé sur la partie centrale du panneau ou d'un module réalisé directement sur la partie centrale du panneau par dépôts successifs de couches de natures appropriées par des procédés de dépôt sous vide.

Au sein de chaque module photovoltaïque, la disposition et l'organisation des cellules photovoltaïques n'est pas limitative. A titre d'exemple non limitatif, les cellules peuvent être disposées les unes sous les autres en une unique rangée ou peuvent être disposées en plusieurs rangées, les rangées étant reliées les unes aux autres de sorte à former une sorte de ruban plié. De préférence, et afin de faciliter la réalisation, directement sur le panneau, de modules photovoltaïques par des procédés de dépôt sous vide, les cellules sont disposées en une unique rangée.

Une colonne 5 de modules photovoltaïques peut ainsi être monolithique, autrement dit être faite d'une seule pièce, ou être constituée d'une pluralité de modules photovoltaïques mis bout à bout en un alignement. La mise bout à bout de deux modules photovoltaïques successifs s'effectue par la mise en contact électrique de la dernière cellule photovoltaïque d'un module et de la première cellule photovoltaïque de l'autre module de sorte que les deux cellules soient reliées en série.

Les colonnes sont alignées sensiblement parallèlement à un bord longitudinal du panneau. De préférence, les colonnes sont de longueur identique et leurs extrémités sont alignées sensiblement parallèlement à un bord transversal du panneau, de sorte à faciliter la connexion des colonnes de deux panneaux adjacents.

Afin de faciliter le câblage d'un assemblage de panneaux, comme cela sera décrit ultérieurement, le dispositif photovoltaïque présente par ailleurs les caractéristiques suivantes :
- Un nombre pair de colonnes,
- chaque colonne comprend un pôle électrique 7 à chacune de ses extrémités, la polarité d'un pôle électrique d'une extrémité étant inverse de celle du pôle électrique de l'autre extrémité,
- les pôles de deux colonnes adjacentes sont de polarité inversée.

La présence des pôles électriques en face supérieure du panneau facilite la connexion des modules entre eux lorsque le panneau est mis en place sur le bâtiment. Il n'est plus nécessaire d'avoir accès à la sous-toiture pour câbler.

De préférence, les colonnes d'un panneau ne sont pas reliées électriquement entre elles. La connexion électrique entre les colonnes ne sera alors réalisée qu'après assemblage des panneaux comme cela sera décrit ultérieurement. Cela simplifie la fabrication du panneau en usine et permet sur chantier d'ajuster le câblage aux spécificités de l'assemblage.

Chaque colonne comprend à l'une de ses extrémités un connecteur mâle faisant office de premier pôle électrique et à son autre extrémité un connecteur femelle faisant office de deuxième pôle électrique, les deux connecteurs étant agencés de sorte qu'ils s'emboitent l'un dans l'autre lorsque le bord transversal inférieur d'un panneau supérieur vient recouvrir le bord transversal supérieur d'un panneau inférieur. On entend par emboitement le fait qu'une partie du connecteur mâle se fiche dans une partie du connecteur femelle lors du rapprochement de deux panneaux adjacents de sorte que les deux panneaux soient reliés électriquement, concomitamment à leur assemblage en toiture, sans qu'il soit nécessaire de procéder à d'autres étapes, telles que, par exemple, le raccordement manuel de deux câbles électriques. A cet effet, une partie du connecteur mâle présente une forme complémentaire d'une partie du connecteur femelle. De préférence, l'axe des connecteurs mâle et femelle est ajusté de sorte à permettre un rapprochement aisé des deux panneaux. De préférence, l'axe est orienté perpendiculairement au panneau. Une telle connexion facilite l'assemblage des panneaux sur un bâtiment et simplifie le câblage de l'installation photovoltaïque.

Le connecteur femelle peut par exemple consister en un boitier situé au niveau du bord transversal inférieur du panneau et comprenant une prise femelle d'axe orienté perpendiculairement au panneau. Le connecteur mâle correspondant consiste, dans ce cas, en une prise mâle, d'axe orienté perpendiculairement au panneau, située au niveau du bord transversal supérieur. Lors de la mise en place du panneau supérieur par translation selon un axe orienté perpendiculairement au panneau inférieur, le connecteur mâle et le connecteur femelle s'emboitent.

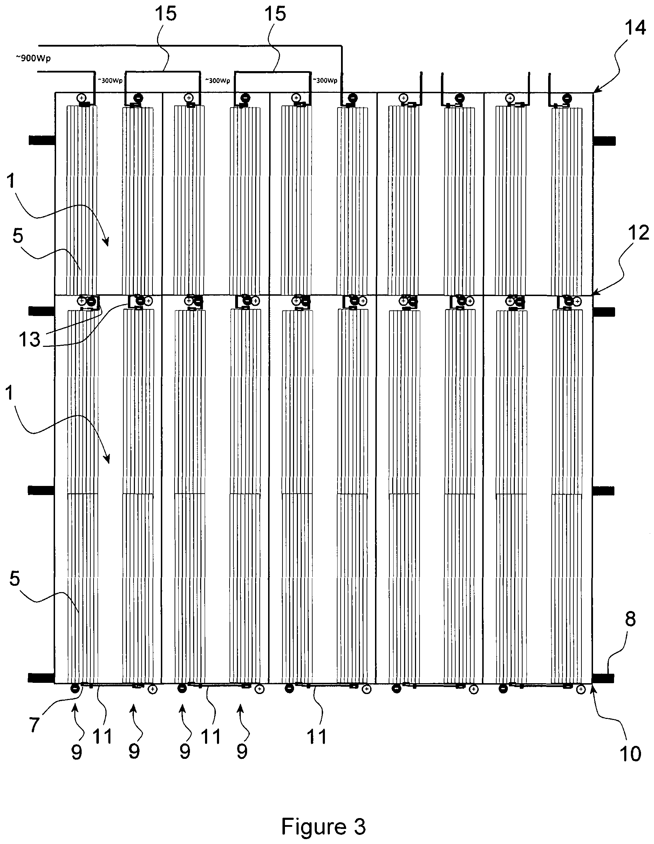

Les panneaux selon l'invention sont de préférence fabriqués en usine puis transportés sur site avant d'être assemblés comme indiqué ci-dessous et à l'appui de la figure 3. D'une part la fabrication en usine de l'intégralité du panneau permet de garantir sa qualité et son bon fonctionnement et d'autre part les opérations d'assemblage sur site sont minimisées grâce à la mise en place en une seule étape du parement extérieur du bâtiment et de l'ensemble photovoltaïque.

De préférence, les panneaux destinés à un assemblage donné présentent chacun une première colonne 5 dont chacun des pôles 7 est de même polarité que le pôle correspondant de la première colonne d'un autre panneau. Les dimensions des panneaux et le nombre de colonnes de modules photovoltaïques des panneaux peuvent cependant varier.

Sur la structure 8 du bâtiment à recouvrir, on fixe un premier panneau 1 par l'intermédiaire de moyens de fixation tels que des vis, des clous ou encore des rivets. De préférence, le panneau est orienté de sorte que ses bords longitudinaux soient dans le sens de la pente. Cette orientation facilite l'écoulement des eaux de pluie sur l'assemblage et préserve l'étanchéité de ce dernier.

Puis un ou plusieurs panneaux sont disposés autour du premier panneau et assemblés entre eux :
- par recouvrement marginal des bords transversaux de panneaux adjacents pour former des rangées de modules photovoltaïques, de sorte que chaque pôle électrique d'une extrémité inférieure d'une colonne de modules photovoltaïques du panneau supérieur soit en regard d'un pôle électrique, de polarité inversée, d'une extrémité supérieure d'une colonne du panneau inférieur.
- et/ou par recouvrement marginal des bords longitudinaux de panneaux adjacents pour multiplier le nombre de rangées,

Une rangée de modules photovoltaïques se définit donc comme une juxtaposition dans le sens longitudinal de colonnes de modules photovoltaïques. En fonction de la forme de la structure à recouvrir et des contraintes locales, telles que par exemple une fenêtre, une porte ou encore une cheminée, les rangées de panneaux pourront être de longueurs variables.

On obtient ainsi un assemblage de panneaux formant une pluralité de rangées 9 de modules photovoltaïques. Chaque panneau étant muni d'un nombre pair de colonnes de modules photovoltaïques, le nombre de rangées est pair. Le nombre de modules photovoltaïques par rangée dépend du nombre de panneaux juxtaposés dans une rangée donnée et est donc susceptible de varier d'une rangée à une autre. Dans le cas d'un panneau ne présentant aucun recouvrement marginal de ses bords transversaux, la rangée de modules photovoltaïque se confond avec la colonne de modules photovoltaïques.

Chaque rangée comprend, un pôle électrique à chacune de ses extrémités, la polarité d'un pôle électrique d'une extrémité étant inverse de celle du pôle électrique de l'autre extrémité et les pôles de deux rangées adjacentes étant de polarité inversée. Autrement dit, chaque rangée comprend, à son extrémité inférieure, un pôle électrique, qui se confond avec le pôle électrique de l'extrémité inférieure de la première colonne de cette rangée, et à son extrémité supérieure, un pôle électrique de polarité inverse, qui se confond avec le pôle électrique de l'extrémité supérieure de la dernière colonne de cette rangée. Deux colonnes adjacentes d'un panneau étant de polarité inverse, on retrouve par ailleurs cette inversion des polarités au niveau de deux rangées adjacentes.

Les colonnes 5 de modules photovoltaïques de chaque panneau sont ensuite raccordées électriquement comme indiqué ci-dessous.

En bas de pente 10 de l'assemblage, le pôle électrique 7 de l'extrémité inférieure de la première rangée 9 est connecté électriquement au pôle électrique de l'extrémité inférieure de la deuxième rangée, le pôle électrique de l'extrémité inférieure de la troisième rangée est connecté électriquement au pôle électrique de l'extrémité inférieure de la quatrième rangée, et ainsi de suite.

En pratique, cette connexion électrique est faite au moyen de connecteurs transversaux 11 tels que, à titre d'exemples non limitatifs, un câble électrique souple ou une barrette électrique rigide. Dans le cas où les pôles électriques des extrémités des rangées sont équipés de connecteurs mâles et femelles, le câble ou la barrette sont prolongés de connecteurs mâles et femelles équivalents, permettant de relier le connecteur de l'extrémité de la rangée au câble ou à la barrette.

Les connecteurs transversaux 11 peuvent par ailleurs comprendre une diode orientée de façon à bloquer le passage du courant du pôle électrique positif vers le pôle électrique négatif et à permettre le passage du courant en sens inverse. Cette diode permet, lorsque cela est nécessaire, de court-circuiter une colonne défectueuse.

Au niveau du recouvrement marginal 12 de deux panneaux adjacents d'une même rangée, le pôle électrique de l'extrémité inférieure de chaque colonne du panneau supérieur est connecté au pôle électrique de polarité inverse en regard sur le panneau inférieur, autrement dit le pôle électrique de l'extrémité supérieure de la colonne correspondante du panneau inférieur.

En pratique, cette connexion électrique est faite par simple emboitement des connecteurs mâle et femelle si les colonnes de modules photovoltaïques en sont munies à leurs extrémités, et cela simultanément à la pose des panneaux. Alternativement, la connexion peut être faite au moyen de connecteurs verticaux 13 similaires aux connecteurs transversaux décrits plus haut.

Au faitage 14, les pôles électriques des extrémités supérieures des rangées sont raccordés au convertisseur ou entre eux de façon similaire à ce qui est fait en bas de pente en fonction de la tension d'entrée acceptable par le convertisseur. Cette tension d'entrée est ajustée en jouant sur le nombre de colonnes connectées entre elles en série. L'homme du métier saura adapter ce principe de connexion au cas par cas. La figure 3 illustre un type de connexion possible au faitage. Le pôle électrique supérieur de la première rangée y est relié au convertisseur. Le pôle électrique supérieur de la deuxième rangée est relié au pôle électrique supérieur de la troisième rangée au moyen d'un connecteur transversal 15 similaire à ceux employés en bas de pente. Le pôle électrique supérieur de la quatrième rangée est relié au pôle électrique supérieur de la cinquième rangée de la même façon. Enfin le pôle électrique supérieur de la sixième rangée est relié au circuit convertisseur. Les n modules photovoltaïques des six premières rangées sont ainsi reliés en série et délivrent au convertisseur une tension égale à n fois leur tension nominale.

Les colonnes suivantes sont ensuite connectées selon le même schéma.

Ainsi la sortie des câbles en direction du convertisseur se fait au faitage, qui est d'accès facile, ce qui facilite leur mise en place ou leur accès en cas de réparation.

Comme le montre le principe de connexion illustré à la figure 3, le nombre pair de colonnes 5, et donc de rangées 9, garantit que le raccordement électrique au convertisseur pourra se faire au faitage sans recourir à aucun long câble électrique courant le long de la toiture. En effet, un nombre impair de colonnes conduirait à une dernière rangée dont le pôle électrique inférieur ne pourrait être relié au faitage au convertisseur qu'au prix du recours à un câble courant sur toute la hauteur de la toiture.

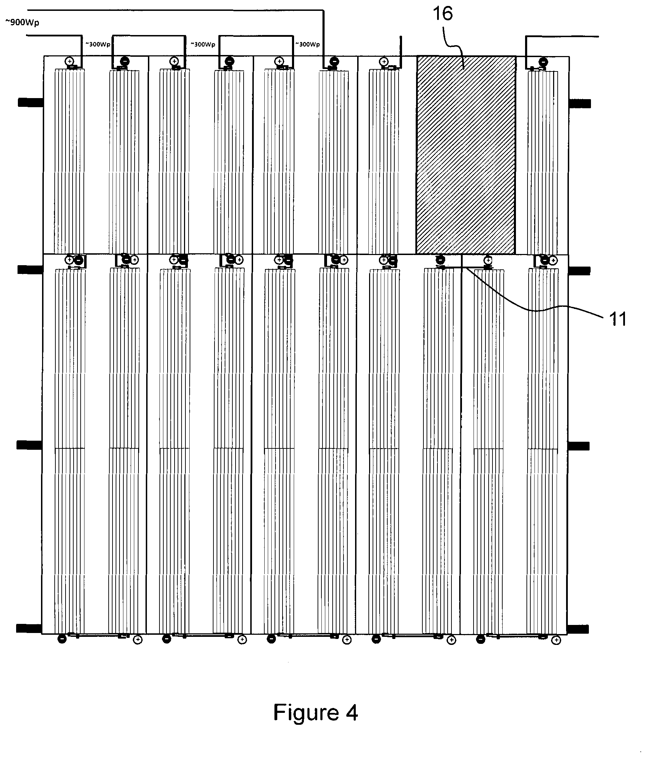

Le recours aux panneaux selon l'invention offre une grande souplesse dans la réalisation du schéma de câblage. Il est ainsi possible d'ajuster le schéma de câblage de l'installation photovoltaïque en cas d'accidents de toiture, tels que, par exemple, une souche de cheminée, une douille de ventilation, une chatière, une lucarne, une trappe d'accès. Comme illustré à la figure 4, un accident de toiture 16 a obligé à découper longitudinalement deux panneaux, chacun de ces deux panneaux ne présentant alors qu'une seule colonne de modules photovoltaïques. En termes de câblage, l'accident de toiture peut aisément être contourné par la simple mise en place d'un connecteur transversal 11 sous l'accident de toiture.

Selon un second mode de réalisation de l'assemblage des panneaux, on peut inverser la façon de connecter les modules en bas de pente et au faitage, de sorte que la sortie des câbles se fasse en bas de pente.

Ainsi, grâce à l'approvisionnement sur chantier de panneaux selon l'invention, il est très facile de mettre les panneaux en position et de connecter simultanément ou après coup les modules photovoltaïques.

## Revendications

1. Panneau (1) muni d'un dispositif photovoltaïque constitué d'un nombre pair de colonnes (5) de modules photovoltaïques, les colonnes étant alignées sensiblement parallèlement à un bord longitudinal du panneau, chaque colonne comprenant un pôle électrique (7) à chacune de ses extrémités, la polarité d'un pôle électrique d'une extrémité étant inverse de celle du pôle électrique de l'autre extrémité, les pôles de deux colonnes adjacentes étant de polarité inversée, le pôle électrique (7) se présentant sous la forme d'un connecteur mâle lorsqu'il est d'une polarité et sous la forme d'un connecteur femelle lorsqu'il est de polarité inverse et les connecteurs mâles et femelles étant agencés de sorte qu'ils s'emboitent les uns dans les autres lorsque le bord transversal inférieur d'un panneau supérieur vient recouvrir le bord transversal supérieur d'un panneau inférieur.

2. Panneau selon la revendication 1 fait d'une tôle métallique mise en forme.

3. Panneau selon l'une quelconque des revendications précédentes pour lequel les modules photovoltaïques sont des rubans souples collés sur le panneau.

4. Panneau selon l'une quelconque des revendications 1 à 2 pour lequel les modules photovoltaïques ont été réalisés directement sur le panneau par dépôts successifs de couches de natures appropriées par des procédés de dépôt sous vide.

5. Panneau selon l'une quelconque des revendications précédentes pour lequel les colonnes (5) ne sont pas reliées électriquement entre elles.

6. Panneau selon l'une quelconque des revendications précédentes pour lequel les colonnes (5) sont de longueur identique et leurs extrémités sont alignées sensiblement parallèlement à un bord transversal du panneau.

7. Assemblage de panneaux selon l'une quelconque des revendications 1 à 6 juxtaposés par recouvrement marginal de leurs bords longitudinaux et/ou de leurs bords transversaux de sorte à former dans le sens longitudinal des rangées (9) de modules photovoltaïques.

8. Dispositif électrique apte à être raccordé à un convertisseur comprenant un assemblage selon la revendication 7 incliné selon une pente donnée pour lequel :
- en bas de pente (10) de l'assemblage, le pôle électrique (7) de l'extrémité inférieure de la première rangée (9) est connecté électriquement au pôle électrique de l'extrémité inférieure de la deuxième rangée, et ainsi de suite,
- au niveau du recouvrement marginal (12) de deux panneaux adjacents d'une même rangée, le pôle électrique de l'extrémité inférieure de chaque colonne du panneau supérieur est connecté au pôle électrique de polarité inverse en regard sur le panneau inférieur,
- au faitage (14), les pôles électriques des extrémités supérieures des rangées sont raccordés au convertisseur ou entre eux de façon similaire à ce qui est fait en bas de pente.

9. Procédé de raccordement électrique, à un convertisseur, des panneaux constitutifs d'un assemblage selon la revendication 7 incliné selon une pente, comprenant les étapes selon lesquelles :
- en bas de pente (10) de l'assemblage, le pôle électrique (7) de l'extrémité inférieure de la première rangée (9) est connecté électriquement au pôle électrique de l'extrémité inférieure de la deuxième rangée, et ainsi de suite,
- Au niveau du recouvrement marginal (12) de deux panneaux adjacents d'une même rangée, le pôle électrique de l'extrémité inférieure de chaque colonne du panneau supérieur est connecté au pôle électrique de polarité inverse en regard sur le panneau inférieur,
- Au faitage (14), les pôles électriques des extrémités supérieures des rangées sont raccordés au convertisseur ou entre eux de façon similaire à ce qui est fait en bas de pente.

## Patentansprüche

1. Tafel (1) mit einer photovoltaischen Vorrichtung ausgestattete, bestehend aus einer geraden Anzahl von Säulen (5) von photovoltaischen Modulen, wobei die Säulen im Wesentlichen parallel zu einem Längsrand der Tafel ausgerichtet sind, wobei jede Säule einen elektrischen Pol (7) an jedem ihrer Enden umfasst, wobei die Polarität eines elektrischen Pols eines Endes umgekehrt zu derjenigen des elektrischen Pols des anderen Endes ist, wobei die Pole von zwei benachbarten Säulen eine umgekehrte Polarität aufweisen, wobei der elektrische Pol (7) die Form eines Steckverbinders aufweist, wenn er einer Polarität ist, und die Form einer Steckdose, wenn er der umgekehrten Polarität ist, und wobei die Steckverbinder und Steckdosen derart angeordnet sind, dass sie sich ineinander schieben, wenn der untere Querrand einer oberen Tafel den oberen Querrand einer unteren Tafel abdeckt.

2. Tafel nach Anspruch 1, hergestellt aus einem geformten metallischen Blech.

3. Tafel nach einem beliebigen der vorhergehenden Ansprüche, für die die photovoltaischen Module flexible Bänder sind, die auf die Tafel geklebt sind.

4. Tafel nach einem beliebigen der Ansprüche 1 bis 2, wobei die photovoltaischen Module direkt auf der Tafel durch aufeinanderfolgende Ablagerungen von Schichten geeigneter Art durch Ablagerungsprozesse unter Vakuum durchgeführt wurden.

5. Tafel nach einem beliebigen der vorhergehenden Ansprüche, wobei die Säulen (5) nicht elektrisch miteinander verbunden sind.

6. Tafel nach einem beliebigen der vorhergehenden Ansprüche, wobei die Säulen (5) eine identische Länge aufweisen und ihre Enden im Wesentlichen parallel zu einem Querrand der Tafel ausgerichtet sind.

7. Anordnung von Tafeln nach einem beliebigen der Ansprüche 1 bis 6, die durch Randüberlagerung ihrer Längsränder und/oder ihrer Querränder aneinander gestellt sind, um in der Längsrichtung Reihen (9) von photovoltaischen Modulen zu bilden.

8. Elektrische Vorrichtung, die ausgelegt ist, um an einen Wandler angeschlossen zu sein, umfassend eine Anordnung nach Anspruch 7, die gemäß einer gegebenen Schräge geneigt ist, wobei:
- an der unteren Seite der Schräge (10) der Anordnung der elektrische Pol (7) des unteren Endes der ersten Reihe (9) elektrisch mit dem elektrischen Pol des unteren Endes der zweiten Reihe verbunden ist, und so weiter,
- auf der Ebene der Randüberlagerung (12) von zwei benachbarten Tafeln einer gleichen Reihe der elektrische Pol des unteren Endes jeder Säule der oberen Tafel mit dem elektrischen Pol umgekehrter Polarität gegenüber auf der unteren Tafel verbunden ist,
- auf dem First (14) die elektrischen Pole der oberen Enden der Reihen mit dem Wandler oder untereinander auf ähnliche Weise verbunden sind, wie dies auf der unteren Seite der Schräge durchgeführt ist.

9. Verfahren zum elektrischen Anschluss an einen Wandler der Tafeln, bestehend aus einer Anordnung nach Anspruch 7, die gemäß einer Schräge geneigt ist, umfassend die Schritte, in denen:
- an der unteren Seite der Schräge (10) der Anordnung der elektrische Pol (7) des unteren Endes der ersten Reihe (9) elektrisch mit dem elektrischen Pol des unteren Endes der zweiten Reihe verbunden ist, und so weiter,
- auf der Ebene der Randüberlagerung (12) von zwei benachbarten Tafeln einer gleichen Reihe der elektrische Pol des unteren Endes jeder Säule der oberen Tafel mit dem elektrischen Pol umgekehrter Polarität gegenüber auf der unteren Tafel verbunden ist,
- auf dem First (14) die elektrischen Pole der oberen Enden der Reihen mit dem Wandler oder untereinander auf ähnliche Weise verbunden sind, wie dies auf der unteren Seite der Schräge durchgeführt ist.

## Claims

1. A panel (1) equipped with a photovoltaic device made up of an even number of columns (5) of photovoltaic modules, the columns being aligned substantially parallel to a longitudinal edge of the panel, each column comprising an electric pole (7) at each of its ends, the polarity of an electric pole at one end being opposite that of the electric pole of the other end, the poles of two adjacent columns having opposite polarities, the electric pole (7) assuming the form of a male connector when it has one polarity and the form of a female connector when it has the opposite polarity and the male and female connectors being arranged such that they nest in one another when the lower transverse edge of an upper panel covers the upper transverse edge of a lower panel.

2. The panel according to claim 1, made from a shaped metal sheet.

3. The panel according to any one of the preceding claims, for which the photovoltaic modules are flexible ribbons glued on the panel.

4. The panel according to any one of claims 1 to 2, for which the photovoltaic modules have been made directly on the panel by successive depositions of layers of appropriate natures using vacuum deposition methods.

5. The panel according to any one of the preceding claims, for which the columns (5) are not electrically connected to one another.

6. The panel according to any one of the preceding claims, for which the columns (5) have an identical length and their ends are aligned substantially parallel to a transverse edge of the panel.

7. Assembly of panels according to any one of claims 1 to 6, juxtaposed by marginal overlap of their longitudinal edges and/or their transverse edges so as to form, in the longitudinal direction, rows (9) of photovoltaic modules.

8. An electrical device able to be connected to a converter comprising an assembly according to claim 7, tilted with a given slope for which:
- at the bottom of the slope (10) of the assembly, the electric pole (7) of the lower end of the first row (9) is electrically connected to the electric pole of the lower end of the second row, and so forth,
- at the marginal overlap (12) of two adjacent panels in a same row, the electric pole of the lower end of each column of the upper panel is connected to the electric pole with opposite polarity facing it on the lower panel,
- at the ridge (14), the electric poles of the upper ends of the rows are connected to the converter or to one another similarly to what is done at the slope bottom.

9. A method for electrically connecting, to a converter, panels making up an assembly according to claim 7 tilted with a slope, comprising the following steps:
- at the slope bottom (10) of the assembly, the electric pole (7) of the lower end of the first row (9) is electrically connected to the electric pole of the lower end of the second row, and so forth,
- at the marginal overlap (12) of two adjacent panels of a same row, the electric pole of the lower end of each column of the upper panel is connected to the electric pole with opposite polarity facing it on the lower panel,
- at the ridge (14), the electric poles of the upper ends of the rows are connected to the converter or to one another similarly to what is done at the slope bottom.
